(19) **Europäisches Patentamt**

**European Patent Office**

**Office européen des brevets**

(11) **EP 0 613 238 B1**

(12) **EUROPEAN PATENT SPECIFICATION**

(45) Date of publication and mention
of the grant of the patent:
**27.09.2000 Bulletin 2000/39**

(51) Int. Cl.⁷: **H03F 1/52**

(21) Application number: **93830071.2**

(22) Date of filing: **24.02.1993**

(54) **Limitation of current absorption under short-to-plus-unpowered (SPU) conditions of the output node of an amplifier**

Strombegrenzung im Kurzschlussbetrieb des Ausgangs eines Verstärkers zur positiven Klemme

Limitation de courant sous les conditions de court-circuitage à la borne d'alimentation positive de la sortie d'un amplificateur

(84) Designated Contracting States:
**DE FR GB IT**

(43) Date of publication of application:
**31.08.1994 Bulletin 1994/35**

(73) Proprietor:
**STMicroelectronics S.r.l.**
**20041 Agrate Brianza (Milano) (IT)**

(72) Inventors:
• **Botti, Edoardo**
 **27029 Vigevano (IT)**

• **Fassina, Andrea**
 **20155 Milano (IT)**
• **Ferrari, Paolo**
 **21013 Gallarate (IT)**

(74) Representative:
**Pellegri, Alberto et al**
**c/o Società Italiana Brevetti S.p.A.**
**Piazza Repubblica, 5**
**21100 Varese (IT)**

(56) References cited:
**EP-A- 0 382 906**

**EP 0 613 238 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

Printed by Xerox (UK) Business Services
2.16.7 (HRS)/3.6

**Description**

*TECHNICAL FIELD*

The present invention relates to a power amplifier of an apparatus that may be connected and powered by a battery of a DC supply, provided with means for preventing destructive breakdown that may be accidentally caused by inadvertently connecting the DC supply to the output terminal of the amplifier while the latter is unpowered.

*BACKGROUND OF THE INVENTION*

The document EP-0382906-A2 discloses a Darlington transistors stage that includes a diode for protecting the stage against supply overvoltages and against applications of a supply voltage of wrong polarity.

During the installation of apparatuses containing power amplifiers, destructive breakdown events caused by inadvertently making erroneous connections of the apparatus to the local DC supply are frequent. The most typical instance is the installation of audio amplifiers, radio receivers, cassette and CD players on vehicles.

The output terminals of power amplifiers are normally provided with some sort of protection against accidental shortcircuits that may inadvertently be caused either toward ground potential or toward the DC supply voltage. However, there are still instances of failures on the field, for which a specific protection has not yet been devised.

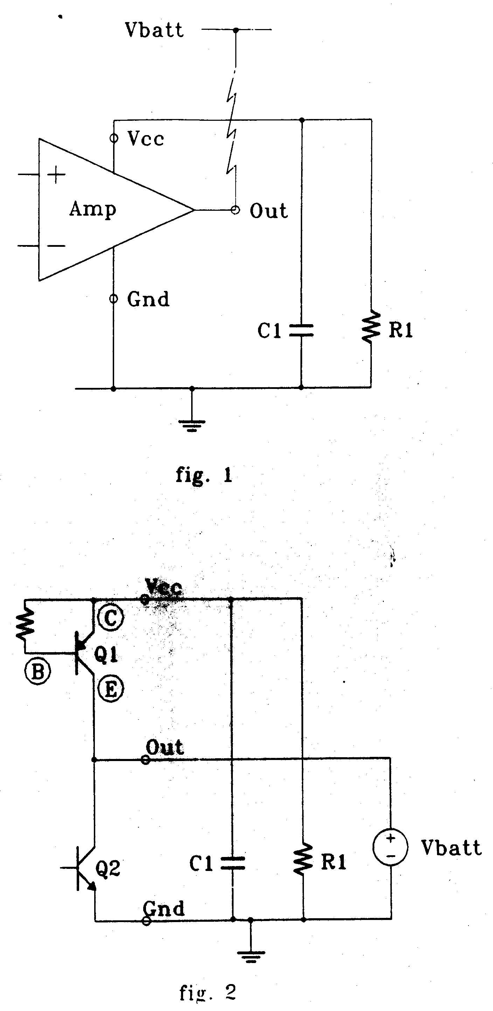

Among these remaining accidental causes of failure there is a condition commonly known as "short-to-plus-unpowered" or more simply by the acronym SPU. Such a condition that may occur during the installation of an apparatus on a vehicle, is schematically depicted in Fig. 1. The accidental cause is an inadvertent connection to the positive pole of the battery ($V_{batt}$) of the vehicle, of the output terminal (Out) of the amplifier (Amp), instead of correctly connecting the supply terminal (Vcc) to the positive pole of the battery ($V_{batt}$). This may happen when the isolated cable coming from the positive pole of the vehicle's battery is connected by error to the output terminal of the card that contains the amplifier. In practice, the output terminal (Out) of the amplifier becomes connected to ground through a filter capacitor C1 that commonly is present on the amplifier card (typically of about a thousand μF) and through an equivalent resistance toward ground R1 of the rest of the circuit on the card (typically in the order of 10 ohms).

When such an accidental connection of the output terminal (Out) of the circuit to the positive node ($V_{batt}$) of the local battery (e.g. of the vehicle), the circuit comes to be "powered" through its output node. Current flows toward ground both through the ground terminal (Gnd) of the amplifier as well as through the supply terminal (Vcc) and the equivalent network formed by R1 and C1, the latter being charged by the current flowing through the Vcc terminal of the amplifier.

Commonly, the output stage of a power amplifier has a push-pull configuration and is composed by a pair of complementary transistors, for example an NPN and a PNP transistor, having their respective collectors connected to the output node of the amplifier (Out). An equivalent circuit, under a SPU condition, is depicted in Fig. 2. In other instances, the output stage of the amplifier may have a bridge configuration and may be formed by transistors of the same type.

In all cases, the power transistor Q1 that is functionally connected between the supply rail and the output node of the stage, and that, as depicted in the figure, may be constituted by an PNP transistor, for example a vertical, isolated collector, PNP transistor (ICVPNP), having an emitter connected to the supply line Vcc of the amplifier, functions in a reverse bias active region, wherein the collector terminal acts as the emitter (E), the base terminal (B) as a base and the emitter terminal as a collector (C).

As in any transistors, also in a reverse bias configuration, the voltage between the "base" and the "collector" should not become greater than a maximum value (dependant on the fabrication technology) in order to avoid breakdown of the junction with an attendant risk of a destructive breakdown because of an excessive power dissipation.

For many fabrication processes, the maximum, voltage that can be tolerated between an emitter (E) and a collector (C) nodes, under reverse bias conditions, may be less than the battery voltage ($V_{batt}$). This makes an SPU condition particularly critical, especially immediately after the occurrence of an accidental short circuit, when the capacitor C1 is discharged and the voltage between the "base" and the "collector" assumes a maximum value that is equal to about: $V_{batt}$ - 0.7V.

It is evident the need and utility of a device capable of preventing failure of the transistor Q1 under short-to-plus-unpowered conditions (SPU). No solutions to this problem are known.

*OBJECTIVE AND SUMMARY OF THE INVENTION*

A main objective of the present invention as it is defined by the appended claims, is to provide a protection for the power transistor of an output stage that is functionally connected between the output node and the supply rail, when a supply voltage is inadvertently applied to the output terminal of the amplifier while the circuit is unpowered.

Basically, the protection system object of the present invention consists in shortcircuiting the base-emitter junction of the said transistor, under reverse bias conditions, when an SPU condition occurs. In practice, a switch that is functionally connected between the base and the collector nodes of the power transistor to be protected automatically closes when an undue application of a supply voltage to the output terminal of the amplifier while the amplifier circuit is unpowered is detected.

In practice the device for detecting an SPU condition and for consequently shortcircuiting the base-collector junction of the power transistor that is subject to a possible destructive breakdown, is unique and is constituted by a transistor that is functionally connected in parallel to the junction to shortcircuit and has a control terminal connected, through a biasing resistance, to the supply rail of the amplifier.

Thanks to this arrangement, and being the breakdown voltage of the base-emitter diode (B/E) in a reverse bias condition, markedly higher than when a transistor-effect is attendant, the power transistor may advantageously be outside the breakdown conditions for voltages that are commonly present under an SPU condition. It is evident that the effectiveness of the solution remains dependant from the fabrication technology of the integrated structures of the transistors. Notwithstanding this fact, the solution object of the present invention provides a decisive contribution to attaining a substantially absolute capacity of the circuit of withstanding an SPU condition.

*BRIEF DESCRIPTION OF THE DRAWINGS*

The different aspects and advantages of the present invention will become clearer through the following description of several important embodiments and by referring to the attached drawings, wherein:

> **Figure 1** is an electrical diagram that describes an accidental SPU condition;
> **Figure 2** puts in evidence the component of an output stage of an amplifier that is more subject to a destructive breakdown as a consequence of the occurrence of an SPU condition;
> **Figure 3** is a partial diagram of the component of the output stage of Fig. 2 that is subject to a possible breakdown, provided with a protection device of the present invention;
> **Figure 4** shows an embodiment of the protection device of the invention;
> **Figure 5** is a functional diagram of the protection device of Fig. 4;
> **Figure 6** depicts a layout of an interdigitated integrated structure of a power transistor, within which an additional SPU protection transistor is formed.

In all the figures, a reverse bias condition of operation of transistors, in an SPU condition, is schematically depicted by the use of letter labels (B) (E) (C) that identify the virtual base node (B), emitter node (E) and collector node (C), respectively, of the transistor structure subject to reverse bias. By contrast, the functional structure is represented by the conventional graphic symbol of the particular type of transistor.

*DESCRIPTION OF PREFERRED EMBODIMENTS*

The criticalness of a reverse bias condition of the output power transistor Q1, connected to the supply rail, of an output stage, under an SPU condition, as depicted in Figures 1 nad 2, may be reduced decisively or eliminated by shortcircuiting through a switch S1 the virtual base-emitter (B)/(E) junction of the transistor. The protecting switch S1 may be driven by a sensor capable of determining the occurrence of an SPU condition, as a consequence of an erroneous connection to the output node Out of the amplifier of the supply battery voltage, while the circuit is unpowered.

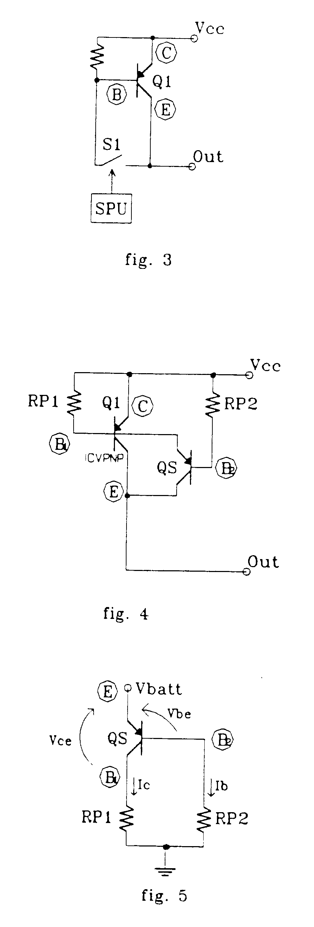

A practical embodiment of a device for detecting an SPU condition and for a shortcircuiting the (B)/(E) junction of the transistor at risk is depicted in Fig. 4. The protection device, according to this embodiment, consists of a transistor QS having an emitter connected to the base ($B_1$) of the power transistor Q1, a collector connected to the output node Out and a base ($B_2$) connected, through a biasing resistance RP2, to the supply rail Vcc of the amplifier circuit.

As may be observed, during a normal functioning of the circuit, the protection transistor QS, substantially of the same type of the power transistor Q1 to be protected, is OFF, because the potentials on the base (node $B_2$) is higher than the potential that are present on the emitter and on the collector nodes. In fact, the base potential is substantially equal to the supply voltage Vcc of the amplifier.

In case of an SPU event, e.g. in absence of power (Vcc=0) and in presence of an accidental connection of the output terminal Out of the amplifier to the supply voltage ($V_{batt}$), the protection transistor QS functions in a reverse saturation zone and therefore the node (E) becomes an emitter node, the node $B_2$ constitutes the base node and the node ($B_1$) becomes a collector node of the protection transistor QS. In these conditions, because the potential on the node ($B_2$) is lower than the potential on the node (E), the protection transistor QS turns ON, thus shortcircuiting in practice the nodes (E) and ($B_1$).

For a correct operation of the protection circuit, the ratio between the biasing resistances RP2 and RP1 and the saturation resistance ($R_{sat}$) of the protection transistor QS should be dimensioned so that the voltage between the nodes (E) and ($B_1$) be insufficient to bring a reverse biased transistor Q1 in conduction. Therefore, the protection transistor QS should saturate with a relatively low voltage between its collector and its emitter, by taking into consideration the collector load RP1.

In view of the fact that the protection device object of the present invention is primarily though not exclusively, devised for monolithically integrated amplifiers, certain considerations will be better understood by referring to the diagram of Fig. 5.

With reference to Fig. 5, it may be noted that the maximum current that the protection transistor QS must conduct is approximately given by the following equation: $I_C \simeq V_{batt}/RP1$ . If RP1 has a relatively low value, the current $I_C$ may be relatively high (for example in the case of a battery voltage: $V_{batt,max}=18V$, and $RP1=150\Omega$ , the current $I_{C,max}$ may be of about 120 mA). This poses a limit to the maximum value of the saturation resistance that the protection transistor QS may have.

Should a lateral type integrated transistor be unable to provide a sufficiently low saturation resistance, the protection transistor QS may be implemented in the form of a vertical transistor with isolated collector, e.g. an ICVPNP, as the power transistor Q1 in the example shown. If, as very probable, the design dimensions of the protection transistor QS are relatively large, it is possible to integrate the protection device, composed of the transistor QS and the biasing resistor RP2, within the same "pocket" that contains the integrated structure of the power transistor Q1, thus saving semiconductor area.

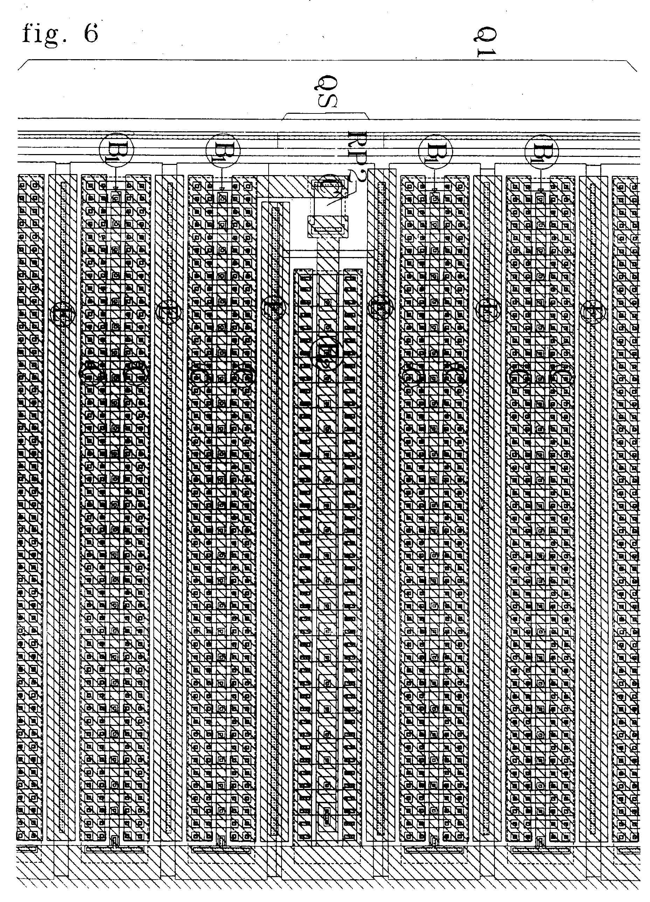

Fig. 6 depicts such integrated embodiment of the protection device of the invention. The protection transistor QS is made in the form of an "additional finger" purposely formed among the fingers of the interdigitated structure of the power transistor Q1. The structure of the protection transistor QS may be substantially similar to the structure of the other fingers belonging to the integrated structure of the power transistor Q1 except for the following peculiarities:

a) because the collector QS (node (E) in Fig. 4) is in common with the collector of the power transistor Q1, the collector structure of the latter may be exploited also as the collector of the additional structure of the protection transistor QS;
b) the emitter of the protection transistor QS (node $(B_1)$ of Fig. 4) may be connected to the base region of the power transistor Q1 through a metal path;
c) the biasing resistance RP2 may be realized by forming a p-type diffusion in an n-type base region of the power transistor Q1, which therefore will represent the "pocket" region of the integrated resistance.

This is possible because the node $(B_1)$ if Fig. 4 under SPU conditions, is at a higher voltage as compared to the integrated "body" of the RP2 resistance and therefore the resistance is correctly biased. Under normal operation conditions, the maximum voltage of the p-type diffusion constituting the RP2 resistance, is equivalent to the supply voltage Vcc and therefore higher than the voltage of the n-type region into which it is formed. This does not jeopardize the normal functioning of the power transistor Q1, because such a p-diffusion (constituting the biasing resistance RP2) behaves as a supplementary "emitter" (relatively of small size) for the transistor Q1. One terminal of RP2 is connected to the base region of the protection transistor QS (node $B_2$,) while the other terminal is connected to the supply metal (node C) that is close by because it is connected to the emitter region of the integrated structure of the power transistor Q1.

## Claims

1.   An output stage comprising a transistor (Q1) having an emitter connected to a supply rail ($V_{cc}$)and a collector connected to an output node (OUT), that may accidentally be connected to a DC voltage source ($V_{batt.}$) characterized in that it comprises

a protection transistor (QS), functionally of the same type of said first transistor and having an emitter connected to a base of said first transistor (Q1), a collector connected to said output node (OUT) and a base connected through a biasing resistance (RP2) to said supply rail ($V_{CC}$), said protection transistor (QS) being turned on by said accidental occurrence and providing a shortcircuiting path between the base and the collector of said first transistor (Q1).

2.   The output stage as defined in claim 1, wherein said first transistor (Q1) and said protection transistor (QS) are both PNP transistors.

3.   The output stage as defined in claim 2, wherein said PNP output transistor (Q1) is a vertical transistor with an isolated collector (ICV PNP) having an interdigitated structure that is contained within an isolated pocket of a monolithically integrated circuit;

said second protection PNP transistor (QS) being formed within said isolated pocket in the form of an additional finger of the interdigitated structure of the output transistor (Q1).

4.   The output stage according to claim 3, wherein said biasing resistance (RP2) is integrated in the form of a diffused region, wholly contained within a base region of said interdigitated structure of said output PNP transistor (Q1).

5.   A method for protecting an integrated PNP transistor (Q1) from the effects of an accidental shortcircuiting of a collector made of said PNP transistor, with a positive voltage source (Vbatt), while the functional circuit of said transistor is unpowered, characterized by comprising:

a) detecting the occurrence of said accidental shortcircuiting of the collector node with the positive voltage source while the circuit is unpowered by the use of a protection transistor (QS) that is turned on by said accidental occurrence;

b) shortcircuiting the base node of said output PNP transistor (Q1) to said collector node through said turned on protection transistor (QS).

## Patentansprüche

1. Ausgangsstufe, mit einem Transistor (Q1), der einen mit einer Versorgungsschiene ($V_{cc}$) verbundenen Emitter und einen mit einem Ausgangsknoten (OUT) verbundenen Kollektor besitzt, wobei der Ausgangsknoten zufällig an eine Gleichspannungsquelle ($V_{batt}$) angeschlossen werden kann, dadurch gekennzeichnet, daß sie enthält:

   einen Schutztransistor (QS), der funktional vom gleichen Typ wie der erste Transistor ist und einen mit einer Basis des ersten Transistors (Q1) verbundenen Emitter, einen mit dem Ausgangsknoten (OUT) verbundenen Kollektor und eine über einen Vorbelastungswiderstand (RP2) mit der Versorgungsschiene ($V_{cc}$) verbundene Basis besitzt, wobei der Schutztransistor (QS) durch das zufällige Auftreten durchschaltet und einen Kurzschlußschaltungspfad zwischen der Basis und dem Kollektor des ersten Transistors (Q1) schafft.

2. Ausgangsstufe nach Anspruch 1, wobei sowohl der erste Transistor (Q1) als auch der Schutztransistor (QS) PNP-Transistoren sind.

3. Ausgangsstufe nach Anspruch 2, wobei der PNP-Ausgangstransistor (Q1) ein vertikaler Transistor mit einem isolierten Kollektor (ICV PNP) ist, der eine interdigitale Struktur aufweist, die in einem isolierten Fach einer monolithischen integrierten Schaltung enthalten ist;
   wobei der zweite Schutz-PNP-Transistor (QS) in dem isolierten Fach in Form eines zusätzlichen Fingers der interdigitalen Struktur des Ausgangstransistors (Q1) ausgebildet ist.

4. Ausgangsstufe nach Anspruch 3, wobei der Vorbelastungswiderstand (RP2) in Form eines diffundierten Bereichs integriert ist, der vollständig in einem Basisbereich der interdigitalen Struktur des Ausgangs-PNP-Transistors (Q1) enthalten ist.

5. Verfahren zum Schützen eines integrierten PNP-Transistors (Q1) vor den Wirkungen eines zufälligen Kurzschließens eines Kollektors des PNP-Transistors mit einer positiven Spannungsquelle ($V_{batt}$), während der funktionale Kreis des Transistors nicht mit Leistung versorgt wird, gekennzeichnet durch

   a) Erfassen des Auftretens des zufälligen Kurzschließens des Kollektorknotens mit der positiven Spannungsquelle, während die Schaltung nicht mit Leistung versorgt wird, unter Verwendung eines Schutztransistors (QS), der durch das zufällige Auftreten durchschaltet;
   b) Kurzschließen des Basisknotens des Ausgangs-PNP-Transistors (Q1) mit dem Kollektorknoten über den durchgeschalteten Schutztransistor (QS).

## Revendications

1. Etage de sortie comprenant un transistor (Q1) ayant un émetteur connecté à un rail d'alimentation ($V_{cc}$) et un collecteur connecté à un noeud de sortie (OUT), qui peut accidentellement être connecté à une source de tension continue ($V_{batt}$), caractérisé en ce qu'il comprend :

   un transistor de protection (QS), fonctionnellement du même type que le premier transistor, ayant un émetteur connecté à la base du premier transistor (Q1), un collecteur connecté au noeud de sortie (OUT) et une base connectée, par l'intermédiaire d'une résistance de polarisation (RP2) au rail d'alimentation ($V_{cc}$),le transistor de protection (QS) étant rendu passant par ladite connexion accidentelle et fournissant un chemin de court-circuit entre la base et le collecteur du premier transistor (Q1).

2. Etage de sortie selon la revendication 1, dans lequel le premier transistor (Q1) et le transistor de protection (QS) sont tous deux des transistors PNP.

3. Etage de sortie selon la revendication 2, dans lequel

   le transistor PNP de sortie (Q1) est un transistor vertical à collecteur isolé (ICVPNP) ayant une structure interdigitée qui est contenu dans un caisson isolé d'un circuit intégré monolithique ;
   le second transistor de protection PNP (QS) est formé à l'intérieur du caisson isolé sous forme d'un doigt supplémentaire de la structure interdigitée du transistor de sortie (Q1).

4. Etage de sortie selon la revendication 3, dans lequel la résistance de polarisation (RP2) est intégrée sous forme d'une région diffusée, totalement contenue à l'intérieur d'une région de base de la structure interdigitée du transistor PNP de sortie (Q1).

5. Procédé de protection d'un transistor PNP intégré (Q1) à l'encontre des effets d'un court-circuit accidentel du collecteur dudit transistor PNP, avec une source de tension positive ($V_{batt}$), tandis que le circuit fonctionnel du transistor n'est pas alimenté, caractérisé en ce qu'il comprend les étapes suivantes :

   a) détecter la survenance dudit court-circuit accidentel du noeud de collecteur avec la source de tension positive tandis que le circuit n'est pas alimenté, par utilisation d'un transistor de protection (QS) qui est rendu passant par ladite survenance accidentelle ; et
   b) court-circuiter le noeud de base du transistor PNP de sortie (Q1) avec le noeud de collecteur par l'intermédiaire dudit transistor de protection (QS) rendu passant.

fig. 1

fig. 2

fig. 3

fig. 4

fig. 5

fig. 6